# EUROPÄISCHE PATENTSCHRIFT

(11) **EP 0 940 010 B1**
(45) Veröffentlichungstag und Bekanntmachung des Hinweises auf die Patenterteilung: **23.05.2001**
(21) Anmeldenummer: 97909281.4
(22) Anmeldetag: 17.09.1997
(51) Int. Cl.: H03K 3/84

(54) **OPTISCHER ZUFALLSGENERATOR BASIEREND AUF DER EINZELPHOTONENSTATISTIK AM OPTISCHEN STRAHLTEILER**
OPTICAL RANDOM-CHECK GENERATOR BASED ON THE INDIVIDUAL PHOTON STATISTICS AT THE OPTICAL BEAM DIVIDER
GENERATEUR OPTIQUE DE NOMBRES ALEATOIRES FONDE SUR LA STATISTIQUE DE PHOTONS INDIVIDUELS AU NIVEAU DU SEPARATEUR OPTIQUE DE FAISCEAU

(30) Priorität: 10.10.1996 DE 19641754
(43) Veröffentlichungstag der Anmeldung: 08.09.1999
(73) Patentinhaber: Deutsche Telekom AG, 53113 Bonn (DE)
(72) Erfinder: DULTZ, Wolfgang, D-65936 Frankfurt am Main (DE); HILDEBRANDT, Eric, D-60487 Frankfurt am Main (DE)
(86) Internationale Anmeldenummer: EP9705082
(87) Internationale Veröffentlichungsnummer: WO9816008

(56) Entgegenhaltungen:
- EP-A- 0 292 733
- WO-A-95/10907
- RARITY J G ET AL: "Quantum random-number generation and key sharing" JOURNAL OF MODERN OPTICS, DEC. 1994, UK, Bd. 41, Nr. 12, ISSN 0950-0340, Seiten 2435-2444, XP002052913 in der Anmeldung erwähnt
- PATENT ABSTRACTS OF JAPAN vol. 017, no. 265 (P-1542), 24.Mai 1993 -& JP 05 005698 A (HITACHI LTD), 14.Januar 1993,

## Beschreibung

Die Erfindung betrifft einen Zufallsgenerator gemäß dem Oberbegriff des Anspruchs 1.

Der Erzeugung von Zufallszahlen kommt heute mehr Bedeutung denn je zu. Nicht nur auf elektronischen Checkkarten, in intelligenten Schließsystemen oder beim On-Line-Zugriff auf Datenbanken spielt die Qualität von Zufallszahlen eine erhebliche, wenn nicht sogar eine Schlüsselrolle. Neben der Menge an benötigten Zufallszahlen, die ständig zunimmt, muß auch sichergestellt sein, daß von außen zugängliche Korrelationen oder Möglichkeiten der Entschlüsselung auf ein Mindestmaß reduziert sind.

Zur Erzeugung von Zufallszahlen wurden bisher im wesentlichen zwei verschiedenartige Klassen von Verfahren angewandt:
1. Algorithmische Verfahren:
   Bei diesen wird aus einer kurzen Anfangssequenz ("seed") mit Hilfe mathematischer Operationen, die in Soft- oder Hardware ausgeführt werden können, eine wesentlich längere pseudo-zufällige Sequenz erzeugt. Die auf dieser Methode basierenden Zufallsgeneratoren sind von sehr unterschiedlicher Qualität und genügen oft kryptographischen Anforderungen nicht; sie haben dafür allerdings die Eigenschaft, reproduzierbare Zufallszahlen zu liefern, was für Simulationen durchaus nützlich sein kann.
2. Physikalische Verfahren:
   Bei diesen nutzt man den statistischen Charakter bestimmter physikalischer Prozesse. Generell lassen diese sich weiter unterteilen in:
   - Statistische Prozesse die zwar deterministischen Bewegungsgleichungen gehorchen, aber aufgrund hoher Komplexität und der Unkenntnis des Anfangszustandes nicht vorhersagbar sind.
   - Fundamental zufällige Prozesse (Elementarprozesse), wie sie von der Quantenmechanik vorhergesagt werden. Sie sind nach dem heutigem Stand der Wissenschaft nicht auf hypothetische deterministische Mechanismen auf Subquantenebene zurückzuführen und daher in ihrer Natur grundsätzlich zufällig.

Bitfolgen, die durch physikalische Prozesse, speziell durch fundamental zufällige, erzeugt werden, kommen dem Konzept einer zufälligen Sequenz näher als algorithmisch generierte Folgen. Schon früh wurde daher erkannt, daß sich z. B. radioaktive Zerfallsmessungen sehr gut eignen, um Zufallssequenzen zu erzeugen, siehe MARTIN GUDE: Ein quasiidealer Gleichverteilungsgenerator basierend auf physikalischen Zufallsphänomenen, Dissertation RWTH Aachen (1987); nachteilig ist hierbei allerdings die potentiell schädliche Wirkung radioaktiver Strahlung auf den Menschen und auf empfindliche Elektronik.

Andere Zufallsgeneratoren benutzen physikalische Rauschquellen, wie z. B. Halbleiter-Dioden, um zufällige Bitsequenzen zu erzeugen, siehe beispielsweise MANFRED RICHTER: Ein Rauschgenerator zur Gewinnung von quasiidealen Zufallszahlen für die stochastische Simulation, Dissertation RWTH Aachen (1992). Bei diesen Verfahren ist es allerdings oft schwierig, die Entscheidungsschwelle (zwischen Bitwert 0 und Bitwert 1) exakt und zeitlich unveränderlich einzustellen. Weiterhin ist es für kryptographische Anwendungen sehr wichtig, äußere Einflußnahme auf den Zufallsmechanismus auszuschließen; dies ist gerade bei der Benutzung elektronischer Phänomene nicht leicht zu erreichen.

Der zufällige Prozeß der Wegwahl einzelner Photonen am Strahlteiler wurde bereits zur Erzeugung von Zufallssequenzen vorgeschlagen, siehe J.G. RARITY et al.: Quantum random-number Generation and key sharing, J. Mod. Opt. 41, S. 2435 bis 2444 (1994). Allerdings kann der zufällige Charakter der Ausgangssequenz durch Störimpulse von außen, sowie fehlerhafte Zählungen der Photonendetektoren gestört werden.

Einzelne Photonen teilen sich am optischen Strahlteiler nicht auf, sondern nehmen zufällig und unvorhersehbar einen der beiden möglichen Wege. Photonendetektoren in den Ausgängen des Strahlteilers generieren daher eine Zufallsfolge, deren Qualität auf den grundlegenden Naturgesetzen der Quantenmechanik beruht. Ein Nachteil des Verfahrens besteht jedoch darin, daß Störpulse der Detektoren, die durch äußere Einwirkungen, etwa durch Höhenstrahlen, verursacht werden und nicht vom zufallsgenerierenden Mechanismus am Strahlteiler herrühren, mit in die Zufallsfolge eingehen. Im Prinzip könnte ein Störer durch Bestrahlen des Aufbaus mit elektromagnetischen Strahlen oder Teilchen die Zufallsfolge gezielt verfälschen.

Ferner ist aus WO 95/10907 ein Entschlüsselungsempfänger bekannt, welcher zwei gleichartige Photonenkanäle aufweist, die je einen Strahlteiler und zwei Photonendetektoren aufweisen. Dabei sind jeweils zwei Detektoren unterschiedlicher Kanäle in Koinzidenz geschaltet. Der Entschlüsselungsempfänger verwendet nachteiligerweise in jedem Kanal einen separaten Detektor zur Triggerung der entsprechenden Koinzidenzschaltung und dient nicht der Erzeugung von Zufallszahlen.

Der Erfindung liegt daher die Aufgabe zu grunde, einen Zufallsgenerator bereitzustellen, der die vorstehenden Nachteile vermeiden oder mindern kann, der gegenüber externen Störungen unanfällig ist und Zufallszahlen hoher Qualität liefert.

Diese Aufgabe wird durch die Merkmale des Anspruchs 1 gelöst.

Da die erfindungsgemäße Photonenquelle zumindest zwei Photonen im wesentlichen gleichzeitig emittieren kann und dabei ein Photon die Erfassungseinrichtung aktiviert, lassen sich hierdurch ungewollte Hintergrundeinflüsse nahezu vollständig vermeiden. Da die Zeit nach dem Aktivieren bzw. Triggern der Erfassungseinrichtung durch das erste Photon so kurz bemessen sein kann, daß im wesentlichen nur das zweite, durch das zufallsgenerierende Element gelaufene Photon für die Erzeugung der Binärzahl genutzt wird (oder wenn die Erfassungseinrichtung nach dem Detektieren des zweiten Photons in den deaktivierten Zustand geschaltet wird,) sind Fehlmessungen nur noch während des sehr kurzen aktivierten bzw. getriggerten Zustands oder durch eine Fehltriggerung möglich. Jedoch selbst in diesen Fällen würden bei der bevorzugten erfindungsgemäßen Ausführung mit einem optischen Strahlteiler mit extrem hoher Wahrscheinlichkeit keine Fehler auftreten, da die einfache Fehltriggerung zu keiner Erfassung eines zweiten Photons führen würde oder andernfalls bei korrekter Triggerung in beiden Teilzweigen des Strahlteilers ein Signal erhalten würde, welches auf elektronischem Wege auf einfache Weise korrigierbar ist.

Besonders vorteilhaft ist es, wenn die Photonenquelle eine Photonenpaarquelle zur gleichzeitigen Erzeugung zweier Photonen mit korrelierter Polarisation, Energie und räumlicher Abstrahlungsverteilung umfaßt, denn dann läßt sich durch den vorbekannten Ausbreitungsweg mittels Blenden, durch die bekannte Polarisation mittels eines Polarisators und durch ein spektrales Filter noch vorhandene Hintergrundstrahlung weitestgehend ausblenden.

Die Funktion des zufallsgenerierenden Elements wird erfindungsgemäß verbessert, da dessen Ausgängen zwei Empfängern zugeordnet sind, die Einzelphotonen detektieren. Dann kann der klare Einzelphotonennachweis verbleibende Unsicherheiten über das erfaßte Photon beseitigen.

Elektronisch läßt sich der erfindungsgemäße Grundgedanke in der Erfassungseinrichtung mit einer kombinierten Koinzidenz/Antikoinzidenz-Elektronik erfassen.

Restliche Fehler eines Strahlteilers oder von dessen Justierung, wie diese in der Regel immer vorkommen, lassen sich weiter unterdrücken, wenn das zufallsgenerierende Element einen polarisierenden Strahlteiler und vorzugsweise eine vorgeschaltete λ/2-Verzögerungsplatte zur Abstimmung des Gesamtteilungsverhältnisses enthält.

Bei einer optimal justierten Anordnung von Strahlteiler und λ/2-Verzögerungsplatte können zukünftige abträgliche Einflüssen in mechanischer Hinsicht dadurch gemildert werden, daß zumindest diese beiden Baugruppen und vorzugsweise die zugeordneten Detektoren in zueinander ausgerichteter Stellung gemeinsam gehalten sind.

In preisgünstiger Ausgestaltung kann das zufallsgenerierende Element einen nicht-polarisierenden Strahlteiler, vorzugsweise eine metallbedampfte Platte und/oder eine dielektrische Schicht, umfassen. Auch bei dieser Ausführungsform können optimale Ergebnisse erzielt werden, wenn zur Abgleichung des optischen Strahlengangs und der Detektionselektronik verstellbare Masken und/oder abstimmbare spektrale Filter in den Ausgängen des Strahlteilers aufgestellt sind.

Die Erfindung wird nachfolgend anhand der beigefügten Zeichnungen und unter Bezugnahme auf bevorzugte Ausführungsformen im einzelnen beschrieben.

Es zeigen:
- Fig. 1: den grundlegenden Aufbau einer erfindungsgemäßen zufallsgenerierenden Einrichtung,
- Fig. 2: eine erste erfindungsgemäße Ausführungsform der einen Laser umfassenden Photonenpaarquelle,
- Fig. 3: eine zweite erfindungsgemäße Ausführungsform der einen Laser umfassenden Photonenpaarquelle und
- Fig. 4: das zufallsgenerierende Element mit zugeordneten Detektoren.

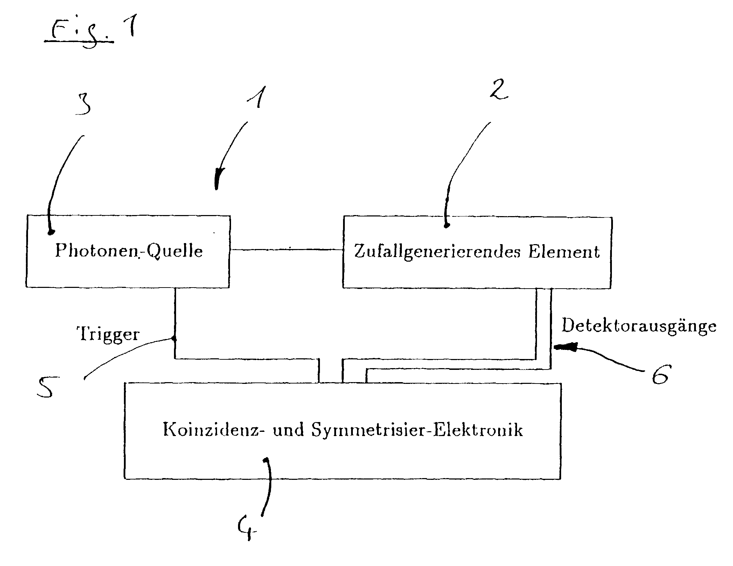

Die Erfindung wird nachfolgend unter Bezugnahme auf die Prinzipdarstellung von Fig. 1 in ihren Grundzügen beschrieben.

Die im Ganzen mit 1 bezeichnete erfindungsgemäße Vorrichtung umfaßt einen Laser 3 als Teil der Photonenquelle, ein zufallsgenerierendes Element 2 und eine Koinzidenz- und Symmetrisierelektronik 4, die über Triggerleitungen 5 aktiviert bzw. getriggert werden kann und dann das Signal der Detektorausgänge 6 empfängt.

Die Erfindung verwendet eine Photonenquelle, bei der jeweils zwei Photonen gleichzeitig in einem nichtlinearen optischen Medium, vorzugsweise einem Kristall 7, erzeugt werden. Beispiele gut geeigneter optischer, nichtlinearer Kristalle sind BaB₂O₄, KNbO₃ oder LiNbO₃, die so mit dem Laser 3 gepumpt werden können, daß Paare korrelierter Photonen der doppelten Wellenlänge mit zueinander orthogonaler Polarisation erzeugt werden. Physikalisch wird dieser Effekt auch als parametrische Fluoreszenz vom Typ 2 bezeichnet.

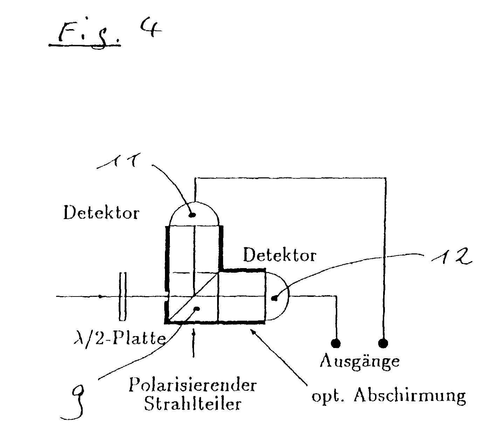

Als Laser 3 wird beispielsweise ein He-Cd-Laser bei einer Betriebswellenlänge von 442 nm eingesetzt, welches Photonen im infraroten Bereich bei 884 nm ergibt. Mit einem als spektralem Filter wirkenden Blauglas 8 wird vor dem Kristall das Plasmaleuchten des Lasers 3 abgeblockt, und ein hinter dem Kristall befindliches spektrales Filter oder Prisma, das in den Figuren nicht dargestellt ist, dient dazu, das Pumplicht des Lasers 3 vom weiteren Strahlengang fernzuhalten. Jedes Photonenpaar wird räumlich aufgeteilt, wobei ein Photon auf einen als zufallsgenerierendes Element wirkenden Strahlteiler 9 fällt, der am besten aus Fig. 4 zu erkennen ist und wobei das andere Photon direkt vom Triggerdetektor 10 erfaßt wird.

In einer in den Figuren nicht dargestellten Erfassungseinrichtung, die auch die Koinzidenz- und Symmetrisier-Elektronik 4 enthält, wird dann nur einer der Detektoren 11, 12 ausgelesen, wenn gleichzeitig oder zeitlich zugeordnet der Triggerdetektor 10 ein Signal liefert.

Die Detektoren 10, 11 und 12 sind Einzelnphotonendetektoren, beispielsweise Si-Avalanche-Photodioden, wie sie von EG&G als Typ C30902 geliefert werden, und werden dann vorzugsweise bei -30°C von einem Peltier-Kühler gekühlt betrieben. Eine in den Figuren nicht dargestellte achromatische Linse kann den Lichtstrahl auf den Detektor fokussieren und die empfangene Intensität erhöhen.

Bei dem hier vorgeschlagenen Verfahren zur Erzeugung von Zufalls-Bitfolgen wird ein fundamentales zufälliges Phänomen benutzt, nämlich die stochastische Aufteilung eines Stromes von Einphotonen-Zuständen am 50:50-Strahlteiler mit nachgeschalteter Einzelquanten-Detektion.

Die Korrelation der Zählereignisse der Detektoren 11 und 12 des Strahlteilers 9 mit dem Signal des Triggerdetektors 10 verbessert die Zufallsfolge und schützt vor äußeren Eingriffen in den optischen Strahlengang.

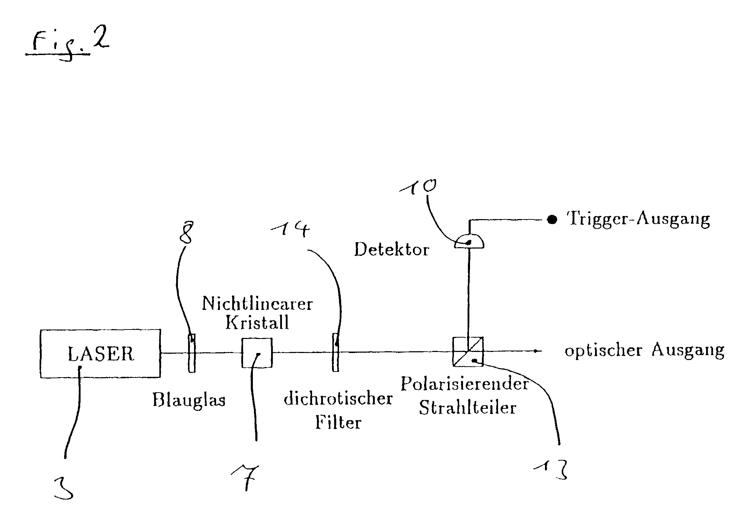

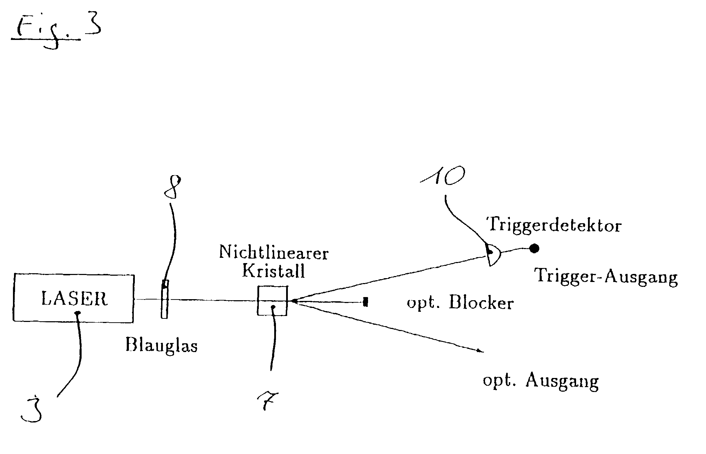

In erfindungsgemäßer Weise können zumindest zwei verschiedene optische Aufbauten verwendet werden, dies ist der in Fig. 2 dargestellte kolineare und der in Fig. 3 dargestellte nichtkolineare, unter einem Winkel zueinander verlaufende Strahlengänge umfassende Aufbau.

Bei dem nichtkolinearen Aufbau der Fig. 3 werden die Photonen bereits bei der Erzeugung im nichtlinearen Kristall 7 dadurch getrennt, daß sie in unterschiedlichen Richtungen propagieren. Die beiden Photonen eines Paares sind nun bereits räumlich getrennt, und ihre Ausbreitungsrichtungen fallen überdies nicht mit der des Lasers zusammen, daher lassen sich gegenüber dem kolinearen Aufbau der Fig. 2 optische Komponenten, insbesondere der polarisierende Strahlteiler 13, sparen, und die optischen Verluste sind entsprechend kleiner.

Bei dem Aufbau der Fig. 3 müssen die Photonen eines Paares nicht mehr unterschiedliche Polarisationsrichtungen haben, und es läßt sich folglich auch die parametrische Fluoreszenz vom Typ 1 benutzen, wodurch zusätzliche Flexibilität bei der Optimierung der Photonenrate gewonnen wird, da je nach verwendeter Kristallsorte die Effizienzen der Prozesse vom Typ 1 oder Typ 2 unterschiedlich sein können.

Der Aufbau des zufallsgenerierenden Elements 2 ist in Fig. 4 genauer dargestellt. Bei einer ersten erfindungsgemäßen Ausführungsform umfaßt das zufallsgenerierende Element einen polarisierenden 50:50-Strahlteiler 9 mit Einzelphotonendetektoren 11, 12 in dessen Ausgängen und mit einer optionalen computergesteuerten drehbaren λ/2-Verzögerungsplatte im Eingang. Durch Drehen dieser λ/2-Platte läßt sich das Gesamtteilungsverhältnis, das aufgrund der Bauteiltoleranzen bei den Detektoren im allgemeinen von 50:50 abweichen würde auf besser als 0,1 % Abweichung vom Idealwert einstellen.

Die Eingangsseite des Strahlteilerwürfels 9 ist durch eine Lochblende bis auf eine Öffnung mit einem Durchmesser φ = 2 mm abgedeckt; außerdem ist der ungenutzte Eingang des Strahlteilers abgedeckt, und die Strahlengänge zu den Detektoren 11, 12 sind gegen Hintergrundlicht optisch abgedichtet.

Anstelle des polarisierenden Strahlteilers 9 kann in alternativer erfindungsgemäßer Ausgestaltung auch ein nicht-polarisierender Strahlteiler verwendet werden, der beispielsweise aus einer bedampften planparallelen oder keilförmigen Platte besteht. Diese Bedampfung kann metallisch oder dielektrisch ausgeführt sein. Hierbei auftretende Abweichungen vom 50:50-Verhältnis im optischen Aufbau oder der Elektronik lassen sich nach dem Strahlteiler durch Masken oder spektrale Filter ausgleichen.

Eine Erfassungseinrichtung, die an einen PC angeschlossen sein kann und diesem binäre Daten oder in beliebiger anderer Darstellung vorliegende Daten zuführen kann, umfaßt die Koinzidenz- und Symmetrisierelektronik 4, welcher die Ausgangssignale der Detektoren 11 und 12 sowie des Triggerdetektors 10 zugeführt sind. Im einfachsten Fall wird hierfür ein UND-Gatter mit einem Zeit-Delay in einem der Eingänge verwendet. Die Ausgangssignale der beiden Koinzidenzeinheiten generieren vorläufige Bitwerte "1" bzw. "0".

Um eine weitere Einschränkung der Einflüsse von Falschlicht und Detektordunkelzählraten zu erreichen, wird aus den Ausgangssignalen der Koinzidenzeinheiten mittels eines EXOR-Gatters ein "Event"-Signal erzeugt, das nur dann auf "HIGH"-Level ist, wenn eine Koinzidenz des TriggerDetektors 10 mit genau einem der beiden Ausgangsdetektoren 11, 12 vorliegt.

Um eine vollständig uniforme "0-1"-Folge zu erzeugen, wird das Ausgangssignal noch mit einer Hardware-Version des "von Neumann-Algorithmus", s. beispielsweise J. von Neumann "Various Techniques Used in Connection with Random Digits", Appl. Math. Ser., 12, Seiten 36-38 (1951), symmetrisiert. Bei diesem Algorithmus wird die Ursprungssequenz zunächst in nichtüberlappende Paare aufeinanderfolgender Bits aufgeteilt und aus diesen Paaren anschließend die Ausgangssequenz nach folgender Vorschrift generiert:

| Bit 1 | Bit 2 | Ausgangs-Bit |
|---|---|---|
| 1 | 1 | - |
| 1 | 0 | 1 |
| 0 | 1 | 0 |
| 0 | 0 | - |

Dieses Verfahren hat zwar den Nachteil einer mindestens 75%igen Reduktion der maximal erreichbaren Bitrate, garantiert jedoch dafür eine exakte 50:50-Verteilung der "0"-en und "1"-en, ohne unerwünschte Korrelationen einzubeziehen, was sich bei anderen Verfahren, die niedrigere Bitrateneinbußen haben, nur schwer ausschließen läßt.

Die auf diese Weise erhaltenen Werte werden in einem Pufferspeicher zwischengespeichert und anschließend von einem Steuerrechner oder einem PC übernommen.

Um eine vorgenommene Justierung stabil aufrechtzuerhalten, kann die erfindungsgemäße Vorrichtung und deren optische und optoelektronische Elemente auf einem eigenen Träger, wie beispielsweise einer zweidimensionalen optischen Bank oder einem mechanisch bearbeiteten Block aus Metall oder Keramik, aufgebaut sein. Darüber hinaus liegt es im Rahmen der Erfindung, sobald Laser in Miniaturgröße mit geeigneten Spektren zur Verfügung stehen, den Zufallsgenerator in integriert-optoelektonischer Ausführungsform zu realisieren.

## Patentansprüche

1. Zufallsgenerator (1) zur Erzeugung einer Zufallszahl, welche vorzugsweise in Binärdarstellung erhalten wird, umfassend eine
- Photonenquelle,
- ein auf von der Photonenquelle emittierte Photonen einwirkendes zufallsgenerierendes Element (2), und
- eine Erfassungseinrichtung, die der Detektion eines aus dem zufallsgenerierenden Element (2) austretenden Photons einen Zahlenwert, vorzugsweise in Binärdarstellung, zuordnet,
dadurch gekennzeichnet,
daß die Photonenquelle eine Photonenpaarquelle zur gleichzeitigen Erzeugung zweier Photonen umfaßt und das eine Photon die Erfassungseinrichtung aktivieren kann, um das andere, durch das zufallsgenerierende Element (2) beeinflußte Photon zu erfassen und um diesem einen Zahlenwert zuzuordnen,
wobei die Erfassungseinrichtung einen Einzelphotonen-Empfänger als Trigger-Detektor (10) zur Detektierung des aktivierenden Photons des Photonenpaars verwendet
und ein Event-Signal erzeugt wird, wenn eine zeitliche Koinzidenz des Signals aus dem Trigger-Detektor (10) mit dem Signal aus einem von zwei Detektoren (11, 12) vorliegt.

2. Zufallsgenerator (1) nach Anspruch 1,
dadurch gekennzeichnet, daß eine Photonenpaarquelle (13) zur gleichzeitigen Erzeugung zweier Photonen mit korrelierter Polarisation, Energie und räumlicher Abstrahlverteilung vorgesehen ist.

3. Zufallsgenerator (1) nach Anspruch 1 oder 2,
dadurch gekennzeichnet,
daß das zufallsgenerierende Element (2) einen Strahlteiler (9) umfaßt, dessen Ausgänge den zwei Detektoren (11, 12), die Einzelphotonen detektieren, zugeordnet sind.

4. Zufallsgenerator (1) nach einem der vorstehenden Ansprüche, dadurch gekennzeichnet, daß die Erfassungseinrichtung eine kombinierte Koinzidenz/Antikoinzidenz-Elektronik (4) umfaßt.

5. Zufallsgenerator (1) nach einem der vorstehenden Ansprüche, dadurch gekennzeichnet, daß das zufallsgenerierende Element (2) einen polarisierenden Strahlteiler (9) und vorzugsweise eine vorgeschaltete λ/2-Verzögerungsplatte zur Abstimmung des Gesamtteilungsverhältnisses enthält

6. Zufallsgenerator (1) nach Anspruch 5,
dadurch gekennzeichnet, daß der polarisierende Strahlteiler (9) und die λ/2-Verzögerungsplatte in zueinander ausgerichteter Stellung gemeinsam gehalten sind.

7. Zufallsgenerator (1) nach einem der vorstehenden Ansprüche von 1 bis 4,
dadurch gekennzeichnet, daß das zufallsgenerierende Element (2) einen nicht-polarisierenden Strahlteiler, vorzugsweise eine metallbedampfte Platte und/oder eine dielektrische Schicht, umfaßt.

8. Zufallsgenerator (1) nach Anspruch 7,
dadurch gekennzeichnet, daß zur Abgleichung des optischen Strahlengangs und der Detektionselektronik (4) verstellbare Masken und/oder abstimmbare spektrale Filter in den Ausgängen des Strahlteilers aufgestellt sind.

9. Zufallsgenerator (1) nach einem der vorstehenden Ansprüche, dadurch gekennzeichnet, daß das Gesamteilungsverhältnis zwischen den einzelnen Ausgängen des zufallsgenerierenden Elementes (2) durch optische und/oder elektronische Einrichtungen auf ein etwa gleiches Teilungsverhältnis, bei Zweiphotonenemission auf etwa 50:50, eingestellt ist.

## Claims

1. A random generator (1) for generating à random number, preferably obtained in binary notation, comprising a
- source of photons,
- a random-generating element (2) acting on photons emitted by the source and
- an acquisition device which associates a numerical value, preferably in binary notation, with detection of a photon coming from the random-generating element (2),
characterised in that
the photon source comprises a source of pairs of photons for generating two photons simultaneously and one photon can activate the acquisition device in order to detect the other photon influenced by the photon-generating element (2) and in order to associate a numerical value therewith,
wherein the acquisition device uses a single-photon receiver as a trigger detector (10) for detecting the activating photon out of the pair of photons and assigns a numerical value when the signal from the trigger detector (10) coincides in time with the signal from one of the two detectors (11, 12).

2. A random generator (1) according to claim 1, characterised in that a source (13) of pairs of photons is provided for simultaneously generating two photons with correlated polarisation, energy and spatial distribution of emitted radiation.

3. A random generator (1) according to claim 1 or 2, characterised in that the random-generating element (2) comprises a beam divider (9) whose outputs are associated with the two detectors (11, 12) which detect individual photons.

4. A random generator (1) according to any of the preceding claims, characterised in that the acquisition device comprises a combined coincidence/anti-coincidence electronic unit (4).

5. A random generator (1) according to any of the preceding claims, characterised in that the random-generating element (2) contains a polarising beam divider (9) and preferably contains an upstream λ/2 delay plate for adjusting the overall division ratio.

6. A random generator (1) according to claim 5, characterised in that the polarising beam divider (9) and the λ/2 delay plate are held together in mutually aligned position.

7. A random generator (1) according to any of the preceding claims 1 to 4, characterised in that the random-generating element (2) comprises a non-polarising beam divider, preferably a metallised plate and/or a dielectric layer.

8. A random generator (1) according to claim 7, characterised in that in order to match the optical path of rays with the detection electronic unit (4), adjustable masks and/or tunable spectral filters are disposed in the outputs of the beam divider.

9. A random generator (1) according to any of the preceding claims, characterised in that the overall division ratio between the individual outputs of the random-generating element (2) is adjusted by optical and/or electronic devices to an approximately equal division ratio, approximately 50 : 50 in the case of two-photon emission.

## Revendications

1. Générateur aléatoire (1) pour la production d'un nombre aléatoire qui est obtenu de préférence en représentation binaire, comprenant
- une source de photons,
- un élément générateur aléatoire (2) agissant sur des photons émis par la source de photons, et
- un dispositif de détection qui associe une valeur numérique, de préférence en représentation binaire, à la détection d'un photon sortant de l'élément générateur aléatoire (2),
caractérisé en ce que
la source de photons comprend une source de paires de photons pour la production simultanée de deux photons et l'un des deux photons peut activer le dispositif de détection pour détecter l'autre photon influencé par l'élément générateur aléatoire (2) et pour lui associer une valeur numérique,
le dispositif de détection utilisant un récepteur de photons individuels en tant que détecteur à déclenchement (10) pour la détection du photon activant de la paire de photons et une valeur numérique étant associée lorsqu'il existe une coïncidence temporelle entre le signal provenant du détecteur à déclenchement (10) et le signal provenant d'un détecteur parmi deux détecteurs (11, 12).

2. Générateur aléatoire (1) selon la revendication 1,
caractérisé en ce qu'il est prévu une source de paires de photons (13) pour la production simultanée de deux photons avec corrélation de la polarisation, de l'énergie et de la distribution spatiale de rayonnement.

3. Générateur aléatoire (1) selon la revendication 1 ou 2, caractérisé en ce que l'élément générateur aléatoire (2) comprend un séparateur de faisceau (9) dont les sorties sont associées aux deux détecteurs (11, 12) qui détectent des photons individuels.

4. Générateur aléatoire (1) selon l'une des revendications précédentes, caractérisé en ce que le dispositif de détection comprend une électronique combinée de coïncidence et d'anticoïncidence (4).

5. Générateur aléatoire (1) selon l'une des revendications précédentes, caractérisé en ce que l'élément générateur aléatoire (2) contient un séparateur de faisceau (9) polarisant et de préférence une plaque de retardement λ/2 branchée en amont pour le réglage du rapport de partage global.

6. Générateur aléatoire (1) selon la revendication 5,
caractérisé en ce que le séparateur de faisceau (9) polarisant et la plaque de retardement λ/2 sont tenus ensemble dans des positions orientées l'une par rapport à l'autre.

7. Générateur aléatoire (1) selon l'une des revendications 1 à 4, caractérisé en ce que l'élément générateur aléatoire (2) comprend un séparateur de faisceau non polarisant, de préférence une plaque métallisée et/ou une couche diélectrique.

8. Générateur aléatoire (1) selon la revendication 7,
caractérisé en ce que, pour ajuster la trajectoire optique des rayons et l'électronique de détection (4), des masques réglables et/ou des filtres spectraux réglables sont placés dans les sorties du séparateur de faisceau.

9. Générateur aléatoire (1) selon l'une des revendications précédentes, caractérisé en ce que le rapport de partage global entre les sorties individuelles de l'élément générateur aléatoire (2) est réglé par des dispositifs optiques et/ou électroniques sur un rapport de séparation à peu près égal, dans le cas de l'émission de deux photons à environ 50 : 50.
